# EUROPÄISCHE PATENTSCHRIFT

(11) **EP 3 504 153 B1**
(45) Veröffentlichungstag und Bekanntmachung des Hinweises auf die Patenterteilung: **03.03.2021**
(21) Anmeldenummer: 17746087.0
(22) Anmeldetag: 31.07.2017
(51) Int. Cl.: B81C 1/00, G01L 9/00, G01L 19/06

(54) **MIKROMECHANISCHES BAUTEIL MIT MEMBRAN, HERSTELLUNGSVERFAHREN FÜR EIN DERARTIGES BAUTEIL UND VERFAHREN ZUM BETREIBEN EINES DRUCKSENSORS**
MICROMECHANICAL COMPONENT WITH MEMBRANE, PRODUCTION PROCESS FOR SUCH A COMPONENT AND METHOD FOR OPERATING A PRESSURE SENSOR
ÉLÉMENT MICRO-MÉCANIQUE À MEMBRANE, PROCÉDÉ DE FABRICATION POUR UN ÉLÉMENT DE CE TYPE ET PROCÉDÉ POUR FAIRE FONCTIONNER UN CAPTEUR DE PRESSION

(30) Priorität: 29.08.2016 DE 102016216229
(43) Veröffentlichungstag der Anmeldung: 03.07.2019
(73) Patentinhaber: Robert Bosch GmbH, 70442 Stuttgart (DE)
(72) Erfinder: REINMUTH, Jochen, 72766 Reutlingen (DE); GRUTZECK, Helmut, 72127Kusterdingen (DE)
(86) Internationale Anmeldenummer: PCT/EP2017/069264
(87) Internationale Veröffentlichungsnummer: WO 2018/041497

(56) Entgegenhaltungen:
- DE-A1-102014 200 500
- US-A1- 2013 234 263

## Beschreibung

Die Erfindung betrifft ein mikromechanisches Bauteil, ein Mikrofon und einen Drucksensor. Ebenso betrifft die Erfindung ein Herstellungsverfahren für ein mikromechanisches Bauteil. Des Weiteren betrifft die Erfindung ein Verfahren zum Betreiben eines Drucksensors.

### Stand der Technik

In der DE 10 2014 200 500 A1 sind eine mikromechanische Drucksensorvorrichtung und ein Herstellungsverfahren zum Herstellen derselben beschrieben. Die mikromechanische Drucksensorvorrichtung hat einen Wafer mit einer durch den Wafer strukturierten Öffnung, welche mittels einer aufgespannten Membran so abgedeckt ist, dass die Membran mittels eines Druckunterschieds zwischen einer Vorderseite des Wafers und einer Rückseite des Wafers verwölbar ist. Außerdem ist mindestens eine Aktorelektrode derart mit der Membran und zusätzlich über eine Federeinrichtung derart mit dem Wafer verbunden, dass die mindestens eine Aktorelektrode mittels einer Verwölbung der Membran entgegen einer Federkraft der Federeinrichtung auslenkbar ist. Die Federeinrichtung ist relativ weich ausgebildet und lässt insbesondere Auslenkungen der mindestens einen Aktorelektrode senkrecht zur Ebene des Wafers zu.

### Offenbarung der Erfindung

Die Erfindung schafft ein mikromechanisches Bauteil mit den Merkmalen des Anspruchs 1, ein Mikrofon mit den Merkmalen des Anspruchs 9, einen Drucksensor mit den Merkmalen des Anspruchs 10, ein Herstellungsverfahren für ein mikromechanisches Bauteil mit den Merkmalen des Anspruchs 12 und ein Verfahren zum Betreiben eines Drucksensors mit den Merkmalen des Anspruchs 13.

### Vorteile der Erfindung

Die vorliegende Erfindung schafft Möglichkeiten zum Sensieren eines Druckunterschiedes zwischen einer ersten Membranseite und einer zweiten Membranseite einer Membran mittels einer sensitiven Komponente (aus der Membran, der mindestens einen Aktorelektrode und der mindestens einen Feder), deren Empfindlichkeit/Sensitivität weniger durch eine Membransteifigkeit der jeweiligen Membran, dafür mehr durch eine Federsteifigkeit der mindestens einen Feder, über welche die mindestens eine Aktorelektrode mit der Halterung verbunden ist, bestimmt ist. Die mindestens eine Aktorelektrode wird vor allem mittels der mindestens einen Feder gehalten, so dass die Federkonstante der einzigen Feder oder eine Gesamt-Federkonstante aller Federn eine druckinduzierte Verformung der Membran und eine druckinduzierte Auslenkung der mindestens einen Aktorelektrode bestimmt. Dies ist vorteilhaft, da die mindestens eine Feder stressfreier realisierbar ist als die (zur Druckabgrenzung ausgelegte und deshalb an ihrem Gesamtumfang eingespannte) Membran. Außerdem kann die mindestens eine Feder, über welche die mindestens eine Aktorelektrode mit der Halterung verbunden ist, in einer anderen Ebene als die Membran, und damit auch mit einer genauer eingehaltenen Federkonstante, gebildet werden. Die Empfindlichkeit/Sensitivität der sensitiven Komponente (aus der Membran, der mindestens einen Aktorelektrode und der mindestens einen Feder) lässt sich somit genauer und verlässlicher auf einen gewünschten Wert festlegen. Die vorliegende Erfindung trägt somit zur Steigerung einer Sensitivität und zur Verbesserung einer Genauigkeit beim Nachweisen von Druckdifferenzen und/oder Messen von Druckdifferenzen bei.

Außerdem kann bei einer Verwendung der vorliegenden Erfindung die Membran sehr weich, d.h. mit einer geringen Steifigkeit, ausgelegt sein. Entsprechend kann die Membran auch vergleichsweise dünn sein. Prozessstreuungen beim Bilden der Membran haben kaum Auswirkungen auf deren spätere Nutzung, da eine Gesamt-Steifigkeit der sensitiven Komponente (aus der Membran, der mindestens einen Aktorelektrode und der mindestens einen Feder) vor allem durch die mindestens eine Federkonstante der mindestens einen Feder definiert ist. Eine dünne Ausbildung der Membran erlaubt auch eine relativ kleinflächige Ausbildung der Membran, wodurch das erfindungsgemäße mikromechanische Bauteil leichter minimierbar ist. Die mittels der vorliegenden Erfindung bewirkbare Minimierung des erfindungsgemäßen mikromechanischen Bauteils erleichtert auch dessen Anbringbarkeit an mindestens einem zu untersuchenden Objekt und steigert zusätzlich dessen Einsetzbarkeit für verschiedene Verwendungszwecke.

Es wird auch darauf hingewiesen, dass die vorliegende Erfindung zur Realisierung von mikromechanischen Bauteilen, Mikrofonen und Drucksensoren beiträgt, welche jeweils nur eine einzige Membran benötigen. Außerdem ist die Verwendung von nur der einen Membran pro mikromechanischem Bauteil, Mikrofon oder Drucksensor flächensparender als eine entsprechende Bereitstellung von mehreren Membranen. Zusätzlich ist es bei der Verwendung einer einzigen Membran leichter möglich, die mindestens eine Aktorelektrode so an die einzige Membran anzubinden, dass kein Risiko einer (unerwünschten) Verkippung der mindestens einen Aktorelektrode bei einer Verwölbung der Membran besteht.

Die Gegenstände der vorliegenden Erfindung reagieren auch weniger empfindlich auf eine Verformung/Verbiegung der Halterung, wie unten genauer erläutert wird.

In einer vorteilhaften Ausführungsform des mikromechanischen Bauteils beträgt die Federkonstante der einzigen Feder oder die Gesamt-Federkonstante aller Federn, über welche die mindestens eine Aktorelektrode mit der Halterung verbunden ist, mindestens 50 % der Gesamtsystemfederkonstante. Eine Gesamt-Steifigkeit der sensitiven Komponente ist damit vor allem durch die Federkonstante der einzigen Feder oder die Gesamt-Federkonstante aller Feder festgelegt. Federkonstanten von Federn sind mittels einfacher Arbeitsschritte, relativ genau und verlässlich festlegbar. Deshalb kann auch die der Gesamt-Steifigkeit entsprechende Empfindlichkeit der sensitiven Komponente mittels einfacher Methoden und verlässlich auf einen gewünschten Wert festgelegt werden. Prozessschwankungen, wie sie beim Bilden der Membran oft auftreten, haben kaum einen Einfluss auf die Empfindlichkeit der sensitiven Komponente.

Außerdem kann die mindestens eine Aktorelektrode mittels der Verwölbung der Membran aus ihrer jeweiligen Ausgangsstellung entlang und/oder parallel zu einer die Membran senkrecht schneidenden Achse entgegen der Federkraft gemäß der mindestens einen Federkonstante der mindestens einen Feder verstellbar sein. Dies kann zur Steigerung einer Nachweisgenauigkeit beim Nachweisen von Druckdifferenzen und/oder Messen von Druckdifferenzen beitragen.

Vorzugsweise ist die mindestens eine Feder, über welche die mindestens eine Aktorelektrode mit der Halterung verbunden ist, mindestens eine U-förmige Feder und/oder mindestens eine mäanderförmige Feder. Derartige Federtypen lassen sich mittels einfacher Ätzschritte aus mindestens einer Halbleiterschicht herausstrukturieren, wobei gleichzeitig die Federkonstante der mindestens einen herausstrukturierten Feder mittels einer Länge, einer Höhe, einer Breite und/oder der U-förmigen und/oder mäanderförmigen Form der mindestens einen Feder verlässlich auf einen gewünschten Wert festlegbar ist.

In einer bevorzugten Ausführungsform des mikromechanischen Bauteils ist die mindestens eine Aktorelektrode über genau vier Federn als die mindestens eine Feder mit der Halterung verbunden. Insbesondere können die genau vier Federn spiegelsymmetrisch bezüglich einer ersten Symmetrieebene und bezüglich einer senkrecht zu der ersten Symmetrieebene ausgerichteten zweiten Symmetrieebene ausgebildet sein. Eine derartige Anbindung der mindestens einen Aktorelektrode an die Halterung reduziert das herkömmliche Risiko einer Verkippung der mindestens einen Aktorelektrode während einer Verwölbung der mindestens einen Feder.

Alternativ kann die mindestens eine Aktorelektrode auch über genau drei Federn als die mindestens eine Feder mit der Halterung verbunden sein. In diesem Fall ist es vorteilhaft, wenn die genau drei Federn drehsymmetrisch bezüglich einer 120°- Drehung ausgebildet sind. Auch mittels einer derartigen Anbindung der mindestens einen Aktorelektrode an die Halterung kann das herkömmliche Risiko einer Verkippung der mindestens einen Aktorelektrode während der Verwölbung der Membran reduziert werden.

Die vorausgehend beschriebenen Vorteile sind auch bei einem Mikrofon mit einem entsprechenden mikromechanischen Bauteil gewährleistet.

Auch ein Drucksensor mit einem derartigen mikromechanischen Bauteil weist die oben beschriebenen Vorteile auf.

In einer bevorzugten Ausführungsform weist der Drucksensor mindestens eine Statorelektrode auf, welche derart an der Halterung und/oder in Bezug zu der Halterung angeordnet ist, dass bei einer Verwölbung der Membran eine Relativbewegung der mindestens einen Statorelektrode in Bezug zu der Halterung unterbunden ist. Vorzugsweise hat der Drucksensor eine Auswerteeinrichtung, welche dazu ausgelegt ist, unter Berücksichtigung mindestens eines Signals bezüglich mindestens einer zwischen der mindestens einen Aktorelektrode und der mindestens einen Statorelektrode vorliegenden Kapazität und unter Berücksichtigung der mindestens einen Federkonstante der mindestens einen Feder einen Ausgangswert bezüglich der Druckdifferenz zwischen der ersten Membranseite und der zweiten Membranseite festzulegen und auszugeben. Durch das Berücksichtigen der mindestens einen Federkonstante der mindestens einen Feder, über welche die mindestens eine Aktorelektrode mit der Halterung verbunden ist, beim Festlegen des Ausgangswerts wird beachtet, dass die Gesamt-Steifigkeit der sensitiven Komponente vor allem durch die mindestens eine Federkonstante der mindestens einen Feder bestimmt ist.

Die oben beschriebenen Vorteile sind auch durch ein Ausführen eines korrespondierenden Herstellungsverfahrens für ein mikromechanisches Bauteil realisierbar. Es wird darauf hingewiesen, dass das Herstellungsverfahren gemäß den oben erläuterten Ausführungsformen des mikromechanischen Bauteils weiterbildbar ist.

Des Weiteren schafft auch ein entsprechendes Verfahren zum Betreiben eines Drucksensors die oben beschriebenen Vorteile. Auch das Verfahren zum Betreiben eines Drucksensors kann gemäß den Ausführungsformen des oben beschriebenen Drucksensors (bzw. seines mikromechanischen Bauteils) weitergebildet werden.

### Kurze Beschreibung der Zeichnungen

Weitere Merkmale und Vorteile der vorliegenden Erfindung werden nachfolgend anhand der Figuren erläutert. Es zeigen:
- Fig. 1a bis 1c: schematische Darstellungen einer Ausführungsform des mikromechanischen Bauteils;
- Fig. 2: ein Flussdiagramm zum Erläutern einer Ausführungsform des Herstellungsverfahrens für ein mikromechanisches Bauteil; und
- Fig. 3: ein Flussdiagramm zum Erläutern einer Ausführungsform des Verfahrens zum Betreiben eines Drucksensors.

### Ausführungsformen der Erfindung

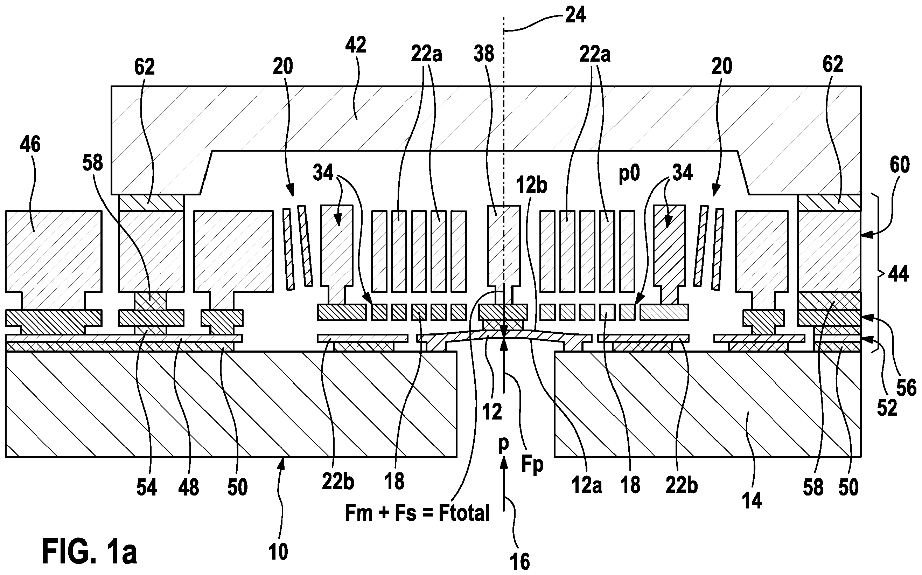

Fig. 1a bis 1c zeigen schematische Darstellungen einer Ausführungsform des mikromechanischen Bauteils.

Das in Fig. 1a bis 1c schematisch dargestellte mikromechanische Bauteil weist eine Halterung 10 mit einer aufgespannten Membran 12 auf. Beispielhaft umfasst die Halterung 10 ein Halbleitersubstrat/einen Halbleiterchip 14 (wie z.B. ein Siliziumsubstrat/einen Siliziumchip 14) mit einer durch das Halbleitersubstrat 14 strukturierten Öffnung 16, welche mittels der Membran 12 luftdicht abgedeckt/verschlossen ist. Die Membran 12 kann beispielsweise ein Außenvolumen der Halterung 10/des mikromechanischen Bauteils mit einem darin vorliegenden Druck p von einem Innenvolumen der Halterung 10/des mikromechanischen Bauteils mit einem darin vorliegenden Referenzdruck p0 (z.B. nahezu Vakuum) abgrenzen.

Bei einer Druckgleichheit auf einer ersten Membranseite 12a der Membran 12 und einer von der ersten Membranseite 12a weg gerichteten zweiten Membranseite 12b der Membran 12, z.B. wenn der Druck p im Außenvolumen gleich dem Referenzdruck p0 im Innenvolumen ist, liegt die Membran 12 in ihrer Ausgangsform vor. Demgegenüber ist die Membran 12 mittels eines Druckunterschieds zwischen der ersten Membranseite 12a und der zweiten Membranseite 12b, z.B. wenn der Druck p im Außenvolumen von dem Differenzdruck p0 im Innenvolumen abweicht, aus ihrer Ausgangsform entgegen einer Membrangegenkraft Fm gemäß einer Membranfederkonstante der Membran 12 verwölbbar. Unter einer mittels des Druckunterschieds induzierten Verwölbung der Membran 12 können eine Einwölbung der Membran 12 in das Innenvolumen der Halterung 10 und/oder eine Auswölbung der Membran 12 auf dem Innenvolumen der Halterung 10 heraus verstanden werden.

Das mikromechanische Bauteil weist auch mindestens eine mit der Membran 12 verbundene Aktorelektrode 18 auf, welche über mindestens eine Feder 20 derart mit der Halterung 10 verbunden, dass die mindestens eine Aktorelektrode 18 mittels der Verwölbung der Membran 12 aus ihrer jeweiligen Ausgangsstellung entgegen einer Federkraft Fs gemäß mindestens einer Federkonstante der mindestens einen Feder 20 verstellbar ist. Damit ist eine Gesamtsystemfederkonstante als Summe der Membranfederkonstante der Membran 12 und der Federkonstante der einzigen Feder 20 oder einer Gesamt-Federkonstante aller Federn 20, über welche die mindestens eine Aktorelektrode 18 mit der Halterung 10 verbunden ist, definierbar. (Unter der Gesamt-Federkonstante kann eine Summe der Federkonstanten aller Federn 20, über welche die mindestens eine Aktorelektrode 18 mit der Halterung 10 verbunden ist, verstanden werden.) Außerdem beträgt die Federkonstante der einzigen Feder 20 oder die Gesamt-Federkonstante aller Federn 20, über welche die mindestens eine Aktorelektrode 18 mit der Halterung 10 verbunden ist, mindestens 5 % der Gesamtsystemfederkonstante.

Die Membran 12, die mindestens eine Aktorelektrode 18 und die mindestens eine Feder 20 bilden damit eine sensitive Komponente (bzw. drucksensitive Komponente) des mikromechanischen Bauteils, welche mittels des Druckunterschieds zwischen der ersten Membranseite 12a und der zweiten Membranseite 12b teils verformbar und teils verstellbar ist. Eine teilweise Verformung und eine teilweise Verstellung der sensitiven Komponente (aus der Membran 12, der mindestens einen Aktorelektrode 18 und der mindestens einen Feder 20) erfolgt so lange, bis eine der teilweisen Verformung und der teilweisen Verstellung entgegen wirkende Gesamtkraft Ftotal gleich einer dem Druckunterschied entsprechend Fp ist. Die Gesamtkraft Ftotal entspricht einer Summe aus der Membrangegenkraft Fm und der Federkraft Fs. Jedoch ist, weil ein Verhältnis der Federkraft Fs zu der Membrangegenkraft Fm gegenüber dem Stand der Technik gesteigert ist, die Gesamtkraft Ftotal stärker durch die Federkraft Fs festgelegt/bestimmt. Man kann dies auch damit umschreiben, dass eine Gesamt-Steifigkeit der sensitiven Komponente (aus der Membran 12, der mindestens einen Aktorelektrode 18 und der mindestens einen Feder 20) stärker durch die Federkonstante der einzigen Feder 20 oder die Gesamt-Federkonstante aller Federn 20 der sensitiven Komponente festgelegt ist. (Demgegenüber hat die Membranfederkonstante der Membran 12 weniger Einfluss auf die Gesamt-Steifigkeit der sensitiven Komponente.)

Bei einem Bilden der Membran 12 treten häufig Prozessstreuungen auf, welche eine genaue Festlegung einer Membransteifigkeit/der Membranfederkonstante der Membran 12 (und damit der Membrangegenkraft Fm) erschweren. Im Vergleich damit lässt sich die mindestens eine Federkonstante der mindestens einen Feder 20 mittels einfach ausführbarer Arbeitsschritte, mit einer vergleichsweise hohen Genauigkeit und einer relativ geringen Fehlerrate auf einem gewünschten Wert festlegen. (Die mindestens eine Feder 20, über welche die mindestens eine Aktorelektrode 18 mit der Halterung 10 verbunden ist, kann beispielsweise mindestens eine U-förmige Feder 20 und/oder mindestens eine mäanderförmige Feder sein.) Die Festlegung der Gesamt-Steifigkeit der sensitiven Komponente stärker durch die Federkonstante der einzigen Feder 20 oder die Gesamt-Federkonstante aller Federn 20 ermöglicht damit ein genaueres und fehlerfreieres Festlegen der Gesamt-Steifigkeit auf einen gewünschten Wert. Die sensitive Komponente (aus der Membran 12, der mindestens einen Aktorelektrode 18 und der mindestens einen Feder 20) kann damit zum genaueren und verlässlicheren Nachweisen/Messen eines Druckunterschieds zwischen der ersten Membranseite 12a und der zweiten Membranseite 12b eingesetzt werden.

Die Membran 12 kann bei dem hier beschriebenen mikromechanischen Bauteil (im Vergleich zu Membranen standardgemäßer membranbestückter Sensorvorrichtungen) relativ weich ausgebildet sein. Dazu kann die Membran 12 mit einem vergleichsweise großen Durchmesser und/oder einer relativ geringen Schichtdicke ausgebildet sein.

Ein weiterer Vorteil des mikromechanischen Bauteils liegt in seiner Unempfindlichkeit gegenüber einem von außen darauf ausgeübten Druck (bzw. gegenüber einer von außen darauf ausgeübten Kraft). Da die Gesamt-Steifigkeit der sensitiven Komponente (aus der Membran 12, der mindestens einen Aktorelektrode 18 und der mindestens einen Feder 20) stark von der Federkonstante der mindestens einen Feder 20 abhängt, hat eine Verformung der Halterung 10, selbst eine Verbiegung des Halbleitersubstrats 14, (nahezu) keine Auswirkungen auf die Gesamt-Steifigkeit der sensitiven Komponente. Dies erleichtert auch ein Verpacken des mikromechanischen Bauteils, beispielsweise durch Auflöten des mikromechanischen Bauteils auf einer (nicht dargestellten) Leiterplatte und/oder Umspritzen des mikromechanischen Bauteils mit einer Moldmasse. Verpackungsmaterialien (wie z.B. Lötmassen und Moldmassen) können aufgrund ihrer thermischen Ausdehnungskoeffizienten mit einem signifikanten Druck (bzw. einer signifikanten Kraft) von außen auf die Halterung 10, insbesondere auf das Halbleitersubstrat 14, einwirken. Eine Funktionsweise/Funktionsfähigkeit des mikromechanischen Bauteils wird jedoch (aufgrund der Festlegung der Gesamt-Steifigkeit der sensitiven Komponente vor allem durch die Federkonstante der einzigen Feder 20 oder die Gesamt-Federkonstante aller Federn 20) von einem derartigen Einwirkung von außen nicht/kaum beeinträchtigt.

Vorzugsweise beträgt die Federkonstante der einzigen Feder 20 oder die Gesamt-Federkonstante aller Federn 20, über welche die mindestens eine Aktorelektrode 18 mit der Halterung 10 verbunden ist, mindestens 50 % der Gesamtsystemfederkonstante. Dies verbessert eine Unempfindlichkeit der sensitiven Komponente (aus der Membran 12, der mindestens einen Aktorelektrode 18 und der mindestens einen Feder 20) gegenüber Prozessstreuungen an der Membran 12 und erleichtert eine Festlegung einer definierten und relativ gering streuenden Gesamt-Steifigkeit der sensitiven Komponente. Zusätzlich verbessert dies auch eine Robustheit der sensitiven Komponente gegenüber einer Verformung der Halterung, insbesondere gegenüber einer Verbiegung des Halbleitersubstrats 14.

In der hier beschriebenen Ausführungsform weist das mikromechanische Bauteil mindestens eine Statorelektrode 22a und 22b auf, welche derart an der Halterung 10 und/oder in Bezug zu der Halterung 10 angeordnet ist, dass bei einer Verwölbung der Membran 12 eine Relativbewegung der mindestens einen Statorelektrode 22a und 22b in Bezug zu der Halterung 10 unterbunden ist. Vorteilhafterweise ist die mindestens eine Statorelektrode 22a und 22b auf einer zu der Membran 12 ausgerichteten Seite der mindestens einen Aktorelektrode 18 und/oder auf einer von der Membran 12 weg gerichteten Seite der mindestens einen Aktorelektrode 18 angeordnet. Außerdem ist die mindestens eine Aktorelektrode 18 mittels der Verwölbung der Membran 12 aus ihrer jeweiligen Ausgangsstellung (entgegen der Federkraft Fs der mindestens einen Feder 20) entlang und/oder parallel zu einer die Membran 12 senkrecht schneidenden Achse 24 verstellbar. Die mindestens eine Aktorelektrode 18 kann somit mittels der Verwölbung der Membran 12 (entlang und/oder parallel zu der Achse 22) direkt auf die mindestens eine Statorelektrode 22a und 22b zubewegt werden und/oder (entlang und/oder parallel zu der Achse 22) direkt von der mindestens einen Statorelektrode 22a und 22b weg bewegt werden. Mittels der Verwölbung der Membran 12 kann somit eine signifikante Kapazitätsänderung mindestens einer Kapazität zwischen der mindestens einen Aktorelektrode 18 und der mindestens einen zugeordneten Statorelektrode 22a und 22b bewirkt werden. Dies kann zum genauen, verlässlichen und fehlerfreien Nachweisen/Messen des Druckunterschieds zwischen der ersten Membranseite 12a und der zweiten Membranseite 12b, d.h. zwischen dem Druck p und dem Differenzdruck p0, genutzt werden.

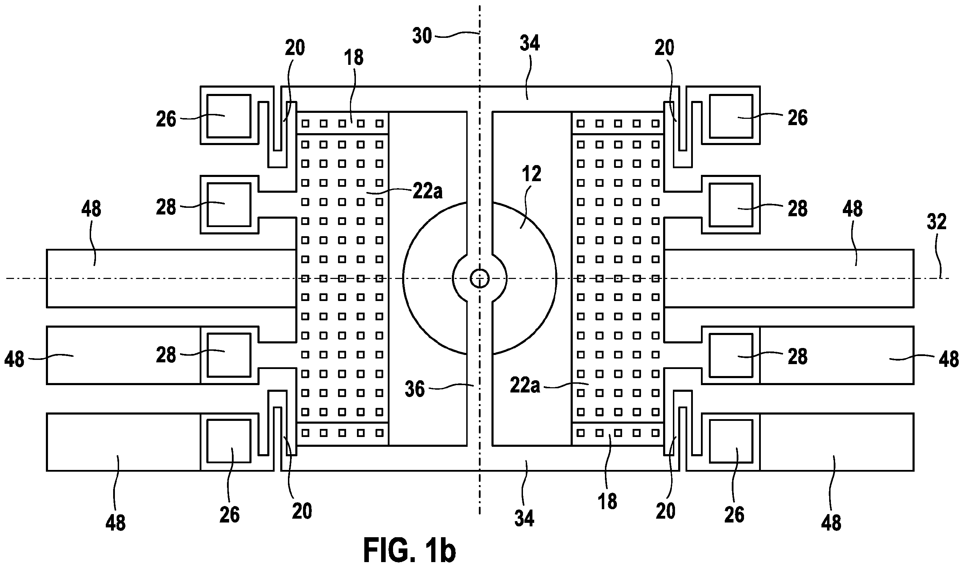

Die Ausführungsform der Fig. 1a bis 1c weist als die mindestens eine Statorelektrode 22a und 22b mindestens eine über dem Halbleitersubstrat 14 aufgehängte (freistehende) Statorelektrode 22a auf ihrer von der Membran 12 weg gerichteten Seite und mindestens eine an dem Halbleitersubstrat 14 angebundene Statorelektrode 22b auf ihrer zu der Membran 12 ausgerichteten Seite auf. Alternativ kann die mindestens eine Statorelektrode 22b auf der zu der Membran 12 ausgerichteten Seite der mindestens einen Aktorelektrode 22a auch als freistehende Elektrode ausgeführt sein. Wie in Fig. 1b erkennbar ist, kann die mindestens eine Feder 20 an der Halterung 10/dem Halbleitersubstrat 14 mittels mindestens einer Federverankerung 26 verankert sein, deren Position gleich oder nahe an mindestens einer Position mindestens einer Elektrodenverankerung 28 liegt, mittels welcher die mindestens eine freistehende Statorelektrode 22a und 22b an der Halterung 10/dem Halbleitersubstrat 14 verankert ist. Eine Verformung der Halterung, insbesondere eine Verbiegung des Halbleitersubstrats 14, löst somit höchstens Bewegungen der Elektroden 18, 22a und 22b aus, welche zueinander derart "angepasst" sind, dass sich die mindestens eine Kapazität zwischen der mindestens einen Aktorelektrode 18 und der mindestens einen zugeordneten Statorelektrode 22a und 22b nicht/kaum ändert. Somit muss auch bei einer Verformung der Halterung, selbst bei einer Verbiegung des Halbleitersubstrats 14 nicht/selten ein Fehlsignal befürchtet werden.

Vorteilhaft ist es, wenn die mindestens zwei Federn 20 zumindest teilweise, insbesondere vollständig, außerhalb eines von den Elektroden 18 und 22a und 22b aufgespannten Volumens angeordnet sind. Bevorzugter Weise sind die mindestens zwei Federn 20 mit einem Abstand von mindestens 50 % eines Radius/Mindestradius der Membran 12 von der Membran 12 beabstandet. Eine derartige Anordnung der mindestens einen Feder 20 relativ weit entfernt von der Membran 12 verhindert ein Verkippen der mindestens einen Aktorelektrode 18 auf effiziente Weise.

Vorzugsweise umfasst das mikromechanische Bauteil mindestens zwei Federn 20, bevorzugter Weise mindestens vier Federn 20, über welche die mindestens eine Aktorelektrode 18 mit der Halterung 10 verbunden ist. Günstig ist es, wenn die mindestens zwei Federn 20 symmetrisch um die Membran 12 angeordnet sind. Auch dies trägt zum Verhindern eines Verkippens der mindestens einen Aktorelektrode 18 bei.

Vorzugsweise ist die Membran 12 zentral angeordnet. Die Membran 12 kann insbesondere mittig zwischen einer geradzahligen Anzahl von Aktorelektroden 18, einer geradzahligen Anzahl von Federn 20 und einer geradzahligen Anzahl von Stator-Elektroden 22a und 22b angeordnet sein. Zwischen der geradzahligen Anzahl von Aktorelektroden 18, der geradzahligen Anzahl von Federn 20 und der geradzahligen Anzahl von Stator-Elektroden 22a und 22b kann eine erste Symmetrieebene 30 verlaufen, bezüglich welcher die Membran 12, die Aktorelektroden 18, die ihnen zugeordneten Statorelektroden 22a und 22b und die Federn spiegelsymmetrisch ausgebildet sind.

Bei der Ausführungsform der Fig. 1a bis 1c ist die mindestens eine Aktorelektrode 18 über genau vier Federn 20 als die mindestens eine Feder 20 mit der Halterung 10 verbunden. Beispielhaft weist das mikromechanische Bauteil zwei Aktorelektroden 18 auf, zwischen welchen die erste Symmetrieebene 30 verläuft. Die genau vier Federn 20 sind auch bezüglich einer senkrecht zu der ersten Symmetrieebene 30 ausgerichteten zweiten Symmetrieebene 32 spiegelsymmetrisch ausgebildet. Die Anzahl von genau vier Federn 20 und deren Symmetrie bezüglich der Symmetrieebenen 30 und 32 reduziert das Risiko eines Verkippens der mindestens einen Aktorelektrode 18 bei deren durch die Verwölbung der Membran 12 bewirkten Auslenkbewegung. Der gleiche Vorteil ist gewährleistet, wenn die mindestens eine Aktorelektrode 18 über genau drei Federn 20 mit der Halterung 10 verbunden ist und die genau drei Federn 20 drehsymmetrisch bezüglich einer 120°- Drehung ausgebildet sind.

Das in Fig. 1a bis 1c schematisch dargestellte mikromechanische Bauteil kann aufgrund der Verkippfreiheit seiner mindestens einen Aktorelektrode 18 vergleichsweise klein und leicht ausgeführt werden. Trotzdem ermöglicht selbst eine minimierte Ausbildung des mikromechanischen Bauteils dessen verlässliche Verwendbarkeit.

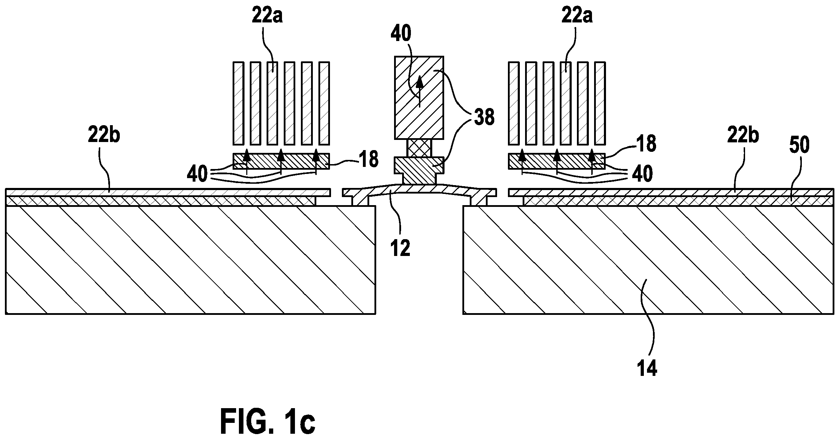

Bei dem mikromechanischen Bauteil der Fig. 1a bis 1c ist die mindestens eine Aktorelektrode 18 Teil eines Aktorelektrodenrahmens 34, welcher über ein erstes Stegelement 36 (in der ersten Symmetrieebene 30) und über ein zweites Stegelement 38 (entlang der Achse 24) mit der Membran 12 verbunden ist. In Fig. 1c geben die Pfeile 40 die durch die Verwölbung der Membran 12 ausgelöste Verstellbewegung des Aktorelektrodenrahmens 34 wieder. Beispielhaft umfasst die Halterung 10 des mikromechanischen Bauteils auch einen Kappenwafer 42, welcher an einem an dem Halbleitersubstrat 14 befestigten Rahmen 44 festgebondet ist. Außerdem weist das mikromechanische Bauteil auch einen außerhalb des Kappenwafers 42 ausgebildeten Kontakt 46 auf, welcher an mindestens einer durch den Rahmen 44 führenden Leiterbahn 48 angebunden ist. Bezüglich weiterer Eigenschaften des mikromechanischen Bauteils wird auf das nachfolgend erläuterte Herstellungsverfahren verwiesen.

Das mikromechanische Bauteil kann z.B. in einem Mikrofon oder in einem Drucksensor vorteilhaft eingesetzt werden. Ein derartiger Drucksensor umfasst vorzugsweise auch eine (nicht dargestellte) Auswerteeinrichtung, welche dazu ausgelegt ist, unter Berücksichtigung mindestens eines Signals bezüglich mindestens einer zwischen der mindestens Aktorelektrode 18 und der mindestens einen Statorelektrode 22a und 22b vorliegenden Kapazität und unter Berücksichtigung der mindestens einen Federkonstante der mindestens einen Feder 20 einen Ausgabewert bezüglich des Druckunterschieds zwischen der ersten Membranseite 12a und der zweiten Membranseite 12b festzulegen und auszugeben. Der Drucksensor kann auch als Teil einer Sensorvorrichtung mit einem anderen Sensortyp, beispielsweise zusammen mit einem Beschleunigungs-, Drehraten- und/oder Magnetfeldsensor, ausgebildet sein.

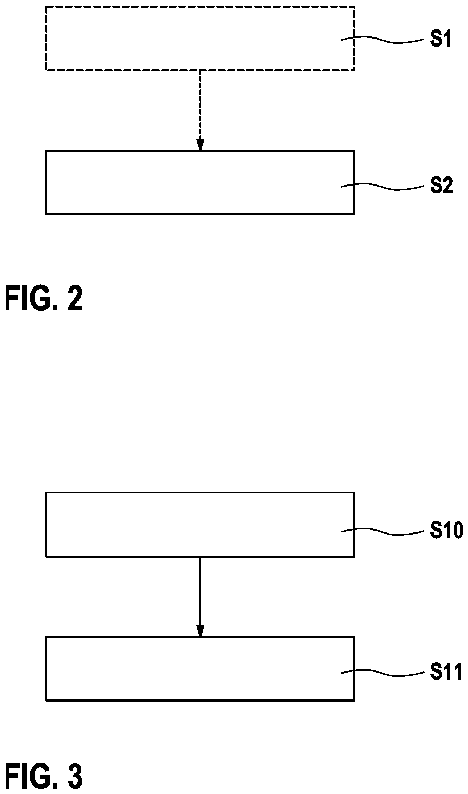

Fig. 2 zeigt ein Flussdiagramm zum Erläutern einer Ausführungsform des Herstellungsverfahrens für ein mikromechanisches Bauteil.

In einem optionalen Verfahrensschritt S1 wird eine Membran an zumindest einem Teil einer Halterung so aufgespannt, dass die Membran bei einer Druckgleichheit auf einer ersten Membranseite der Membran und einer zweiten Membranseite der Membran in ihrer Ausgangsform vorliegt und mittels eines Druckunterschieds zwischen der ersten Membranseite und der zweiten Membranseite aus ihrer Ausgangsform entgegen einer Membrangegenkraft gemäß einer Membranfederkonstante der Membran verwölbt wird. Als Alternative zu einem Ausführen des Verfahrensschritts S1 kann auch eine entsprechend vorgefertigte Membran zum Ausführen eines Verfahrensschritts S2 verwendet werden.

In dem Verfahrensschritt S2 wird mindesten eine Aktorelektrode über mindestens eine Feder an der Halterung angebunden. Außerdem wird die mindestens eine Aktorelektrode so mit der Membran verbunden, dass die mindestens eine Aktorelektrode mittels einer Verwölbung der Membran aus ihrer jeweiligen Ausgangsstellung entgegen einer Federkraft gemäß mindestens einer Federkonstante der mindestens einen Feder verstellt wird. Somit ist eine Gesamtsystemfederkonstante als Summe der Membranfederkonstante der Membran und der Federkonstante der einzigen Feder oder einer Gesamt-Federkonstante aller Federn, über welche die mindestens eine Aktorelektrode mit der Halterung verbunden wird, definierbar. Zusätzlich wird die Federkonstante der einzigen Feder oder die Gesamt-Federkonstante aller Federn, über welche die mindestens eine Aktorelektrode mit der Halterung verbunden wird, auf mindestens 5 % der Gesamtsystemfederkonstante festgelegt.

Als Ausgangsmaterial zum Ausführen der Verfahrensschritte S1 und S2 kann ein Schichtaufbau verwendet werden, wie er in Fig. 1 restweise zu erkennen ist: Auf dem Halbleitersubstrat 14 wird (vor oder nach dem Strukturieren der Öffnung 16) zuerst eine erste Isolierschicht 50, wie z.B. eine Siliziumdioxidschicht, gebildet. Dann wird eine erste Halbleiterschicht 52, insbesondere eine dünne PolysiliziumSchicht, auf der ersten Isolierschicht 50 gebildet. Aus der ersten Halbleiterschicht 52 können (später) die Membran 12, die Statorelektroden 22b, die mindestens eine Leiterbahn 48 und Teile des Rahmens 44 heraus strukturiert werden. Die erste Halbleiterschicht 52 wird zumindest teilweise mit einer zweiten Isolierschicht 54, wie z.B. einer Siliziumdioxidschicht, abgedeckt. Auf der zweiten Isolierschicht 54 wird eine zweite Halbleiterschicht 56, vorzugsweise eine mittlere polykristalline Siliziumschicht, abgeschieden. Aus der zweiten Halbleiterschicht 56 werden später die mindestens eine Aktorelektrode 18, Teile des Rahmens 44 und ein Teil des Kontakts 46 heraus strukturiert. Eine dritte Isolierschicht 58 (z.B. eine Siliziumdioxidschicht) deckt die zweite Halbleiterschicht 56 zumindest teilweise ab. Anschließend wird eine dritte Halbleiterschicht 60, vorzugsweise eine dicke Epi-Polysiliziumschicht, auf der dritten Isolierschicht 58 abgeschieden.

Aus der dritten Halbleiterschicht 60 werden (später) die Federn 20, die Statorelektroden 22a, der Aktorelektrodenrahmen 34, die Stegelemente 36 und 38, Teile des Rahmens 44 und ein Teil des Kontakts 46 heraus strukturiert.

Nach einem Ausführen mindestens eines Ätzprozesses zum Strukturieren des Schichtaufbaus kann noch der Kappenwafer 42 über eine Bondverbindung 62 hermetisch an den Rahmen 44 gebondet werden. Der Kappenwafer 42 dient einerseits als Schutz für die empfindlichen Strukturen, andererseits kann mittels des Bondverfahrens ein definierter Druck als Referenzdruck p0 in dem Innenvolumen eingestellt werden.

Fig. 3 zeigt ein Flussdiagramm zum Erläutern einer Ausführungsform des Verfahrens zum Betreiben eines Drucksensors.

Zum Ausführen des hier erläuterten Verfahrens kann auch das mikromechanische Bauteil der Fig. 1 eingesetzt werden. Es wird jedoch darauf hingewiesen, dass eine Ausführbarkeit des Verfahrens lediglich einen Drucksensor mit einer Halterung, einer daran aufgespannten Membran, mindestens einer mit der Membran verbundenen Aktorelektrode, welche über mindestens eine Feder mit der Halterung verbunden ist, und mindestens einer Statorelektrode erfordert, wobei eine Gesamtsystemfederkonstante als Summe einer Membranfederkonstante der Membran und einer einzigen Federkonstante oder einer Gesamt-Federkonstante der mindestens einen Feder definierbar ist, und wobei die einzige Federkonstante oder die Gesamt-Federkonstante der mindestens einen Feder mindestens 5 % der Gesamtsystemfederkonstante beträgt.

In einem Verfahrensschritt S10 wird mindestens eine Sensor-Größe bezüglich mindestens einer zwischen der mindestens einen Aktorelektrode und der mindestens einen Statorelektrode vorliegenden Kapazität ermittelt. Dies geschieht, während die Membran, welche bei einer Druckgleichheit auf einer ersten Membranseite der Membran und einer zweiten Membranseite der Membran in ihrer Ausgangsform vorliegt, mittels eines Druckunterschieds zwischen der ersten Membranseite und der zweiten Membranseite aus ihrer Ausgangsform entgegen einer Membrangegenkraft gemäß der Membranfederkonstante der Membran verwölbt wird, und die mindestens eine Aktorelektrode mittels der verwölbten Membran aus ihrer jeweiligen Ausgangsstellung entgegen einer Federkraft gemäß der mindestens einen Federkonstante der mindestens einen Feder verstellt wird.

Anschließend wird in einem Verfahrensschritt S11 ein Wert bezüglich des Druckunterschieds zwischen der ersten Membranseite und der zweiten Membranseite festgelegt. Das Festlegen des Wertes erfolgt unter Berücksichtigung der mindestens einen Federkonstante der mindestens einen Feder und der mindestens einen ermittelten Sensor-Größe.

## Patentansprüche

1. Mikromechanisches Bauteil mit:
einer Halterung (10) mit einer aufgespannten Membran (12), welche bei einer Druckgleichheit auf einer ersten Membranseite (12a) der Membran (12) und einer zweiten Membranseite (12b) der Membran (12) in ihrer Ausgangsform vorliegt und mittels eines Druckunterschieds zwischen der ersten Membranseite (12a) und der zweiten Membranseite (12b) aus ihrer Ausgangsform entgegen einer Membrangegenkraft (Fm) gemäß einer Membranfederkonstante der Membran (12) verwölbbar ist; und
mindestens einer mit der Membran (12) verbundenen Aktorelektrode (18), welche über mindestens eine Feder (20) derart mit der Halterung (10) verbunden ist, dass die mindestens eine Aktorelektrode (18) mittels einer Verwölbung der Membran (12) aus ihrer jeweiligen Ausgangsstellung entgegen einer Federkraft (Fs) gemäß mindestens einer Federkonstante der mindestens einen Feder (20) verstellbar ist;
wobei eine Gesamtsystemfederkonstante als Summe der Membranfederkonstante der Membran (12) und der Federkonstante der einzigen Feder (20) oder einer Gesamt-Federkonstante aller Federn (20), über welche die mindestens eine Aktorelektrode (18) mit der Halterung (10) verbunden ist, definierbar ist,
**dadurch gekennzeichnet, dass**
die Federkonstante der einzigen Feder oder die Gesamt-Federkonstante aller Federn (20), über welche die mindestens eine Aktorelektrode (18) mit der Halterung (10) verbunden ist, mindestens 5 % der Gesamtsystemfederkonstante beträgt.

2. Mikromechanisches Bauteil nach Anspruch 1, wobei die Federkonstante der einzigen Feder oder die Gesamt-Federkonstante aller Federn (20), über welche die mindestens eine Aktorelektrode (18) mit der Halterung (10) verbunden ist, mindestens 50 % der Gesamtsystemfederkonstante beträgt.

3. Mikromechanisches Bauteil nach Anspruch 1 oder 2, wobei die mindestens eine Aktorelektrode (18) mittels der Verwölbung der Membran (12) aus ihrer jeweiligen Ausgangsstellung entlang und/oder parallel zu einer die Membran (12) senkrecht schneidenden Achse (22) entgegen der Federkraft (Fs) gemäß der mindestens einen Federkonstante der mindestens einen Feder (20) verstellbar ist.

4. Mikromechanisches Bauteil nach einem der vorhergehenden Ansprüche, wobei die mindestens eine Feder (20), über welche die mindestens eine Aktorelektrode (18) mit der Halterung (10) verbunden ist, mindestens eine U-förmige Feder (20) und/oder mindestens eine mäanderförmige Feder ist.

5. Mikromechanisches Bauteil nach einem der vorhergehenden Ansprüche, wobei die mindestens eine Aktorelektrode (28) über genau vier Federn (20) als die mindestens eine Feder (20) mit der Halterung (10) verbunden ist.

6. Mikromechanisches Bauteil nach Anspruch 5, wobei die genau vier Federn (20) spiegelsymmetrisch bezüglich einer ersten Symmetrieebene (30) und bezüglich einer senkrecht zu der ersten Symmetrieebene (30) ausgerichteten zweiten Symmetrieebene (32) ausgebildet sind.

7. Mikromechanisches Bauteil nach einem der Ansprüche 1 bis 4, wobei die mindestens eine Aktorelektrode über genau drei Federn als die mindestens eine Feder (20) mit der Halterung (10) verbunden ist.

8. Mikromechanisches Bauteil nach Anspruch 7, wobei die genau drei Federn drehsymmetrisch bezüglich einer 120°- Drehung ausgebildet sind.

9. Mikrophon mit einem mikromechanischen Bauteil nach einem der vorhergehenden Ansprüche.

10. Drucksensor mit einem mikromechanischen Bauteil nach einem der Ansprüche 1 bis 8.

11. Drucksensor nach Anspruch 10, wobei der Drucksensor mindestens eine Statorelektrode (22a, 22b) aufweist, welcher derart an der Halterung (10) und/oder in Bezug zu der Halterung (10) angeordnet ist, dass bei einer Verwölbung der Membran (12) eine Relativbewegung der mindestens einen Statorelektrode (22a, 22b) in Bezug zu der Halterung (10) unterbunden ist, und wobei der Drucksensor eine Auswerteeinrichtung umfasst, welche dazu ausgelegt ist, unter Berücksichtigung mindestens eines Signals bezüglich mindestens einer zwischen der mindestens Aktorelektrode (18) und der mindestens eine Statorelektrode (22a, 22b) vorliegenden Kapazität und unter Berücksichtigung der mindestens einen Federkonstante der mindestens einen Feder (20) einen Ausgabewert bezüglich des Druckunterschieds zwischen der ersten Membranseite (12a) und der zweiten Membranseite (12b) festzulegen und auszugeben.

12. Herstellungsverfahren für ein mikromechanisches Bauteil mit den Schritten:
Anbinden mindesten einer Aktorelektrode (18) über mindestens eine Feder (20) an eine Halterung (10) mit einer aufgespannten Membran (12), welche bei einer Druckgleichheit auf einer ersten Membranseite (12a) der Membran (12) und einer zweiten Membranseite (12b) der Membran (12) in ihrer Ausgangsform vorliegt und mittels eines Druckunterschieds zwischen der ersten Membranseite (12a) und der zweiten Membranseite (12b) aus ihrer Ausgangsform entgegen einer Membrangegenkraft (Fm) gemäß einer Membranfederkonstante der Membran (12) verwölbt wird;
wobei die mindestens eine Aktorelektrode (18) so mit der Membran (12) verbunden wird, dass die mindestens eine Aktorelektrode (18) mittels einer Verwölbung der Membran (12) aus ihrer jeweiligen Ausgangsstellung entgegen einer Federkraft (Fs) gemäß mindestens einer Federkonstante der mindestens einen Feder (20) verstellt wird;
und wobei eine Gesamtsystemfederkonstante als Summe der Membranfederkonstante der Membran (12) und der Federkonstante der einzigen Feder (20) oder einer Gesamt-Federkonstante aller Federn (20), über welche die mindestens eine Aktorelektrode (18) mit der Halterung (10) verbunden wird, definierbar ist,
**dadurch gekennzeichnet, dass**
die Federkonstante der einzigen Feder oder die Gesamt-Federkonstante aller Federn (20), über welche die mindestens eine Aktorelektrode (18) mit der Halterung (10) verbunden wird, auf mindestens 5 % der Gesamtsystemfederkonstante festgelegt wird (S2).

13. Verfahren zum Betreiben eines Drucksensors mit einer Halterung (10) mit einer aufgespannten Membran (12), mindestens einer mit der Membran (12) verbundenen Aktorelektrode (18), welche über mindestens eine Feder (20) mit der Halterung (10) verbunden ist, und mindestens einer Statorelektrode (22a, 22b), wobei eine Gesamtsystemfederkonstante als Summe einer Membranfederkonstante der Membran (12) und einer einzigen Federkonstante oder einer Gesamt-Federkonstante der mindestens einen Feder (20) definierbar ist, und wobei die einzige Federkonstante oder die Gesamt-Federkonstante der mindestens einen Feder (20) mindestens 5 % der Gesamtsystemfederkonstante beträgt, mit den Schritten:
Ermitteln mindestens einer Sensor-Größe bezüglich mindestens einer zwischen der mindestens einen Aktorelektrode (18) und der mindestens einen Statorelektrode (22a, 22b) vorliegenden Kapazität, während die Membran (12), welche bei einer Druckgleichheit auf einer ersten Membranseite (12a) der Membran (12) und einer zweiten Membranseite (12b) der Membran (12) in ihrer Ausgangsform vorliegt, mittels eines Druckunterschieds zwischen der ersten Membranseite (12a) und der zweiten Membranseite (12b) aus ihrer Ausgangsform entgegen der Membrangegenkraft (Fm) gemäß der Membranfederkonstante der Membran (12) verwölbt wird, und die mindestens eine Aktorelektrode (18) mittels der verwölbten Membran (12) aus ihrer jeweiligen Ausgangsstellung entgegen einer Federkraft (Fs) gemäß der mindestens einen Federkonstante der mindestens einen Feder (20) verstellt wird (S10); und
Festlegen eines Werts bezüglich des Druckunterschieds zwischen der ersten Membranseite (12a) und der zweiten Membranseite (12b) unter Berücksichtigung der mindestens einen Federkonstante der mindestens einen Feder (20) und der mindestens einen ermittelten Sensor-Größe (S11).

## Claims

1. Micromechanical component, comprising:
a holder (10) with a stretched membrane (12) which, in the case of a pressure equality on a first membrane side (12a) of the membrane (12) and a second membrane side (12b) of the membrane (12), is present in its initial form and can be bent out of its initial form against a membrane counterforce (Fm) according to a membrane spring constant of the membrane (12) by means of a pressure difference between the first membrane side (12a) and the second membrane side (12b); and
at least one actuator electrode (18) which is connected to the membrane (12) and is connected to the holder (10) by means of at least one spring (20) in such a way that the at least one actuator electrode (18) can be adjusted by means of bending of the membrane (12) out of its respective initial position against a spring force (Fs) according to at least one spring constant of the at least one spring (20);
wherein a total system spring constant can be defined as the sum of the spring membrane constant of the membrane (12) and the spring constant of the single spring (20) or a total spring constant of all springs (20) by means of which the at least one actuator electrode (18) is connected to the holder (10),
**characterized in that**
the spring constant of the single spring or the total spring constant of all springs (20) by means of which the at least one actuator electrode (18) is connected to the holder (10) is at least 5% of the total system spring constant.

2. Micromechanical component according to Claim 1, wherein the spring constant of the single spring or the total spring constant of all springs (20) by means of which the at least one actuator electrode (18) is connected to the holder (10) is at least 50% of the total system spring constant.

3. Micromechanical component according to Claim 1 or 2, wherein the at least one actuator electrode (18) can be adjusted by means of the bending of the membrane (12) out of its respective initial position along and/or parallel to an axis (22), which perpendicularly intersects the membrane (12), against the spring force (Fs) according to the at least one spring constant of the at least one spring (20) .

4. Micromechanical component according to one of the preceding claims, wherein the at least one spring (20) by means of which the at least one actuator electrode (18) is connected to the holder (10) is at least one U-shaped spring (20) and/or at least one meandering spring.

5. Micromechanical component according to one of the preceding claims, wherein the at least one actuator electrode (28) is connected to the holder (10) by means of precisely four springs (20) as the at least one spring (20) .

6. Micromechanical component according to Claim 5, wherein the precisely four springs (20) are formed with mirror-image symmetry with respect to a first plane of symmetry (30) and with respect to a second plane of symmetry (32) which is oriented perpendicularly to the first plane of symmetry (30).

7. Micromechanical component according to one of Claims 1 to 4, wherein the at least one actuator electrode is connected to the holder (10) by means of precisely three springs as the at least one spring (20).

8. Micromechanical component according to Claim 7, wherein the precisely three springs are formed rotationally symmetrically with respect to a 120° rotation.

9. Microphone comprising a micromechanical component according to one of the preceding claims.

10. Pressure sensor comprising a micromechanical component according to one of Claims 1 to 8.

11. Pressure sensor according to Claim 10, wherein the pressure sensor has at least one stator electrode (22a, 22b) which is arranged on the holder (10) and/or with respect to the holder (10) in such a way that, when the membrane (12) bends, a relative movement of the at least one stator electrode (22a, 22b) with respect to the holder (10) is suppressed, and wherein the pressure sensor comprises an evaluation device which is designed to define and output an output value relating to the pressure difference between the first membrane side (12a) and the second membrane side (12b) taking into account at least one signal relating to at least one capacitance which is present between the at least one actuator electrode (18) and the at least one stator electrode (22a, 22b) and taking into account the at least one spring constant of the at least one spring (20).

12. Production method for a micromechanical component, comprising the steps of:
connecting at least one actuator electrode (18) to a holder (10) with a stretched membrane (12) by means of at least one spring (20), which stretched membrane, in the case of a pressure equality on a first membrane side (12a) of the membrane (12) and a second membrane side (12b) of the membrane (12), is present in its initial form and is bent out of its initial form against a membrane counterforce (Fm) according to a membrane spring constant of the membrane (12) by means of a pressure difference between the first membrane side (12a) and the second membrane side (12b);
wherein the at least one actuator electrode (18) is connected to the membrane (12) such that the at least one actuator electrode (18) is adjusted by means of bending of the membrane (12) out of its respective initial position against a spring force (Fs) according to at least one spring constant of the at least one spring (20) ;
and wherein a total system spring constant can be defined as the sum of the membrane spring constant of the membrane (12) and the spring constant of the single spring (20) or a total spring constant of all springs (20) by means of which the at least one actuator electrode (18) is connected to the holder (10),
**characterized in that**
the spring constant of the single spring or the total spring constant of all springs (20) by means of which the at least one actuator electrode (18) is connected to the holder (10) is defined (S2) at at least 5% of the total system spring constant.

13. Method for operating a pressure sensor comprising a holder (10) with a stretched membrane (12), at least one actuator electrode (18) which is connected to the membrane (12) and is connected to the holder (10) by means of at least one spring (20), and at least one stator electrode (22a, 22b), wherein the total system spring constant can be defined as the sum of a membrane spring constant of the membrane (12) and a single spring constant or a total spring constant of the at least one spring (20), and wherein the single spring constant or the total spring constant of the at least one spring (20) is at least 5% of the total system spring constant, comprising the steps of:
determining at least one sensor variable relating to at least one capacitance which is present between the at least one actuator electrode (18) and the at least one stator electrode (22a, 22b), while the membrane (12), which is present in its initial form in the case of a pressure equality on a first membrane side (12a) of the membrane (12) and a second membrane side (12b) of the membrane (12), is bent out of its initial shape against the membrane counterforce (Fm) according to the membrane spring constant of the membrane (12) by means of a pressure difference between the first membrane side (12a) and the second membrane side (12b), and the at least one actuator electrode (18) is adjusted (S10) out of its respective initial position against a spring force (Fs) according to the at least one spring constant of the at least one spring (20) by means of the bent membrane (12); and
defining a value relating to the pressure difference between the first membrane side (12a) and the second membrane side (12b) taking into account the at least one spring constant of the at least one spring (20) and the at least one determined sensor variable (S11).

## Revendications

1. Composant micromécanique comprenant :
un support (10) pourvu d'une membrane (12) qui est tendue sur celui-ci, qui est dans sa forme initiale lorsque la pression est la même sur un premier côté (12a) de la membrane (12) et sur un deuxième côté (12b) de la membrane (12), et qui peut être incurvée depuis sa forme initiale, en s'opposant à une force de membrane antagoniste (Fm) selon une constante de rappel de la membrane (12), au moyen d'une différence de pression entre le premier côté (12a) de la membrane et le deuxième côté (12b) de la membrane ; et
au moins une électrode d'actionnement (18) qui est reliée à la membrane (12) et qui est reliée au support (10) par le biais d'au moins un ressort (20) de telle sorte que l'au moins une électrode d'actionnement (18) peut être déplacée par incurvation de la membrane (12) depuis sa position initiale respective en s'opposant à une force de rappel (Fs) selon au moins une constante de rappel de l'au moins un ressort (20) ;
une constante de rappel de système totale pouvant être définie comme la somme de la constante de rappel de la membrane (12) et de la constante de rappel de l'unique ressort (20) ou d'une constante de rappel totale de tous les ressorts (20) qui relient l'au moins une électrode d'actionnement (18) au support (10),
**caractérisé en ce que**
la constante de rappel de l'unique ressort ou la constante de rappel totale de tous les ressorts (20) qui relient l'au moins une électrode d'actionnement (18) au support (10) représente au moins 5 % de la constante de rappel de système totale.

2. Composant micromécanique selon la revendication 1, la constante de rappel de l'unique ressort ou la constante de rappel totale de tous les ressorts (20), qui relient l'au moins une électrode d'actionnement (18) au support (10), est d'au moins 50 % de la constante de rappel de système totale.

3. Composant micromécanique selon la revendication 1 ou 2, l'au moins une électrode d'actionnement (18) peut être déplacée par incurvation de la membrane (12) depuis sa position initiale respective le long d'un axe (22) et/ou parallèlement à un axe (22) coupant perpendiculairement la membrane (12) en s'opposant à la force de rappel (Fs) selon l'au moins une constante de rappel de l'au moins un ressort (20).

4. Composant micromécanique selon l'une des revendications précédentes, l'au moins un ressort (20), qui relie l'au moins une électrode d'actionnement (18) au support (10), étant au moins un ressort (20) en forme de U et/ou au moins un ressort en forme de méandre.

5. Composant micromécanique selon l'une des revendications précédentes, l'au moins une électrode d'actionnement (28) étant reliée au support (10) par le biais d'exactement quatre ressorts (20) constituant l'au moins un ressort (20).

6. Composant micromécanique selon la revendication 5, les exactement quatre ressorts (20) étant à symétrique spéculaire par rapport à un premier plan de symétrie (30) et par rapport à un deuxième plan de symétrie (32) orienté perpendiculairement au premier plan de symétrie (30) .

7. Composant micromécanique selon l'une des revendications 1 à 4, l'au moins une électrode d'actionnement étant reliée au support (10) par le biais d'exactement trois ressorts constituant l'au moins un ressort (20) .

8. Composant micromécanique selon la revendication 7, les exactement trois ressorts étant conçus pour être à symétrie de révolution par rapport à une rotation de 120°.

9. Microphone comprenant un composant micromécanique selon l'une des revendications précédentes.

10. Capteur de pression comprenant un composant micromécanique selon l'une des revendications 1 à 8.

11. Capteur de pression selon la revendication 10, le capteur de pression comportant au moins une électrode de stator (22a, 22b) qui est disposée sur le support (10) et/ou par rapport au support (10) de manière à empêcher un mouvement relatif de l'au moins une électrode de stator (22a, 22b) par rapport au support (10) lors d'une incurvation de la membrane (12), et le capteur de pression comprenant un dispositif d'évaluation qui est conçu pour spécifier et délivrer en sortie une valeur de sortie relative à la différence de pression entre le premier côté de la membrane (12a) et le deuxième côté de la membrane (12b) en prenant en compte au moins un signal relatif à au moins une capacité présente entre l'au moins une électrode d'actionnement (18) et l'au moins une électrode de stator (22a, 22b) et en prenant en compte l'au moins une constante de rappel de l'au moins un ressort (20).

12. Procédé de fabrication d'un composant micromécanique, le procédé comprenant les étapes suivantes :
fixer au moins une électrode d'actionnement (18) par le biais d'au moins un ressort (20) à un support (10) pourvu d'une membrane (12) qui est tendue sur celui-ci, qui est dans sa forme initiale lorsque la pression est la même sur un premier côté (12a) de la membrane (12) et sur un deuxième côté (12b) de la membrane (12), et qui peut être incurvée depuis de sa forme initiale, en s'opposant à une force de membrane antagoniste (Fm) selon une constante de rappel de la membrane (12), au moyen d'une différence de pression entre le premier côté (12a) de la membrane et le deuxième côté (12b) de la membrane ;
l'au moins une électrode d'actionnement (18) étant reliée à la membrane (12) de telle sorte que l'au moins une électrode d'actionnement (18) puisse être déplacée par incurvation de la membrane (12) depuis sa position initiale respective en s'opposant à une force de rappel (Fs) selon au moins une constante de rappel de l'au moins un ressort (20) ;
et une constante de rappel de système totale pouvant être définie comme la somme de la constante de rappel de la membrane (12) et de la constante de rappel de l'unique ressort (20) ou d'une constante de rappel totale de tous les ressorts (20) qui relient l'au moins une électrode d'actionnement (18) au support (10),
**caractérisé en ce que**
la constante de rappel de l'unique ressort ou la constante de rappel totale de tous les ressorts (20), qui relient l'au moins une électrode d'actionnement (18) au support (10), est spécifiée (S2) à au moins 5 % de la constante de rappel de système totale.

13. Procédé de fonctionnement d'un capteur de pression comprenant un support (10) pourvu d'une membrane (12) tendue sur celui-ci, au moins une électrode d'actionnement (18) reliée à la membrane (12) et reliée au support (10) par le biais d'au moins un ressort (20) et au moins une électrode de stator (22a, 22b), une constante de rappel de système totale pouvant être définie comme la somme d'une constante de rappel de la membrane (12) et d'une unique constante de rappel ou d'une constante de rappel totale de l'au moins un ressort (20), et l'unique constante de rappel ou la constante de rappel totale de l'au moins un ressort (20) étant d'au moins 5 % de la constante de rappel de système totale, le procédé comprenant les étapes suivantes :
déterminer au moins une grandeur de capteur relative à au moins une capacité présente entre l'au moins une électrode d'actionnement (18) et l'au moins une électrode de stator (22a, 22b), tandis que la membrane (12), qui se trouve dans sa forme initiale lorsque la pression est la même sur un premier côté (12a) de la membrane (12) et sur un deuxième côté (12b) de la membrane (12), est incurvée depuis sa forme initiale en s'opposant à la force de membrane antagoniste (Fm) selon la constante de rappel de la membrane (12) par une différence de pression entre le premier côté (12a) de la membrane et le deuxième côté (12b) de la membrane et l'au moins une électrode d'actionnement (18) est déplacée (S10) depuis sa position initiale respective en s'opposant à une force de rappel (Fs) selon l'au moins une constante de rappel de l'au moins un ressort (20) au moyen de la membrane incurvée (12) ; et
spécifier une valeur relative à la différence de pression entre le premier côté (12a) de la membrane et le deuxième côté (12b) de la membrane avec prise en compte de l'au moins une constante de rappel de l'au moins un ressort (20) et de l'au moins une grandeur de capteur déterminée (S11).
